# EUROPEAN PATENT SPECIFICATION

(11) **EP 0 609 967 B1**
(45) Date of publication and mention of the grant of the patent: **11.03.1998**
(21) Application number: 94200973.9
(22) Date of filing: 28.06.1991
(51) Int. Cl.: G06F 1/10

(54) **Apparatus for detecting phase errors**
Gerät zum Erkennen von Phasenfehlern
Appareil pour détecter des erreurs de phase

(30) Priority: 29.06.1990 US 545887; 02.10.1990 US 591726
(43) Date of publication of application: 10.08.1994
(62) Divisional of application: 91913180.5
(73) Proprietor: ANALOG DEVICES, INCORPORATED, Norwood, MA 02062-9106 (US)
(72) Inventor: Koker,Gregory T., Stoughton Massachusetts 02072-4522 (US); Tsang,Steven T., West Newton Massachusetts 02165 (US)
(74) Representative: Warren, Anthony Robert

(56) References cited:
- US-A- 4 672 639
- US-A- 4 849 996
- IBM TECHNICAL DISCLOSURE BULLETIN vol. 9, no. 11 , April 1967 , NEW YORK US pages 1558 - 1559 C. E. DORRELL ET C. D. SOUTHARD 'Clocking circuit'

## Description

The present invention relates to apparatus for generating multiple phase clock signals and to phase detectors, and more particularly to a phase detector for correcting the phase of one or more clock signals produced by a synchronous delay line or similar device.

There exist applications in which there is a need to generate multiple internal clock phases or sub-phases from a single input clock, all of which are synchronized together, wherein the generated clock signals are corrected for phase and frequency errors, particularly phase errors of integral multiples of 360°. The apparatus embodying the present invention is capable of fulfilling that need.

It has been a general practice to employ MOS synchronous delay lines to provide additional timing edges from a reference clock signal. Although such devices have served the purpose, they have not proven entirely satisfactory under all conditions of service because, particularly with larger frequency range requirements, there is a need to correct the outputs of such delay lines for phase not only within a range of 0-360°, but also to correct phase errors which are integral multiples of 360°. Such correction is needed so that the outputs remain relatively in phase with each other. The apparatus embodying the present invention is capable of overcoming this problem.

One such synchronous delay line is described in Bazes, M., "A Novel Precision MOS Synchronous Delay Line" in IEEE Journal of Solid-State Circuits, Vol. SC-20, No. 6, December 1985, pp. 1265-1271, which is hereby incorporated by reference. Such a delay line is also described in U.S. Patent No. 4,496,861. An integrated phase-locked loop including phase detection is described in Johnson, M. G. and Hudson, E. L., "A Variable Delay Line PLL for CPU-Coprocessor Synchronization" in IEEE Journal of Solid-State Circuits, Vol. 23, No. 5, October 1988, pp. 1218-1223, which is also hereby incorporated by reference. However, the delay lines, and the phase detectors of Johnson and Hudson, and of Bazes, can be operated over only a limited frequency range, and are subject to start-up or fractional frequency lock-up problems, since a known precision clock input is required. If the user needs more flexible clocking requirements, then problems can occur. In Bazes and especially in Johnson and Hudson, the clock waveform input is very controlled and limited to a very small frequency variation. If the user, erroneously or otherwise, would alter the clock frequency in the middle of a cycle, or power the system up and down, then the system of 3azes, and the system of Johnson and Hudson, would likely not operate properly.

IBM Technical Disclosure Bulletin, Vol. 9, No. 11, April 1967, pages 1558 - 9 , C.E.Dorrell et al : "Clocking Circuit" illustrates a typical cascaded delay line but without a phase detection and error correction circuit. U.S. Patent No. 4,849,996 relates to phase perturbation systems for use in modems. U.S. Patent No. 4,672,639 relates to a circuit for selecting an optimum phase signal but is not directed to phase error correction as is the apparatus embodying the present invention.

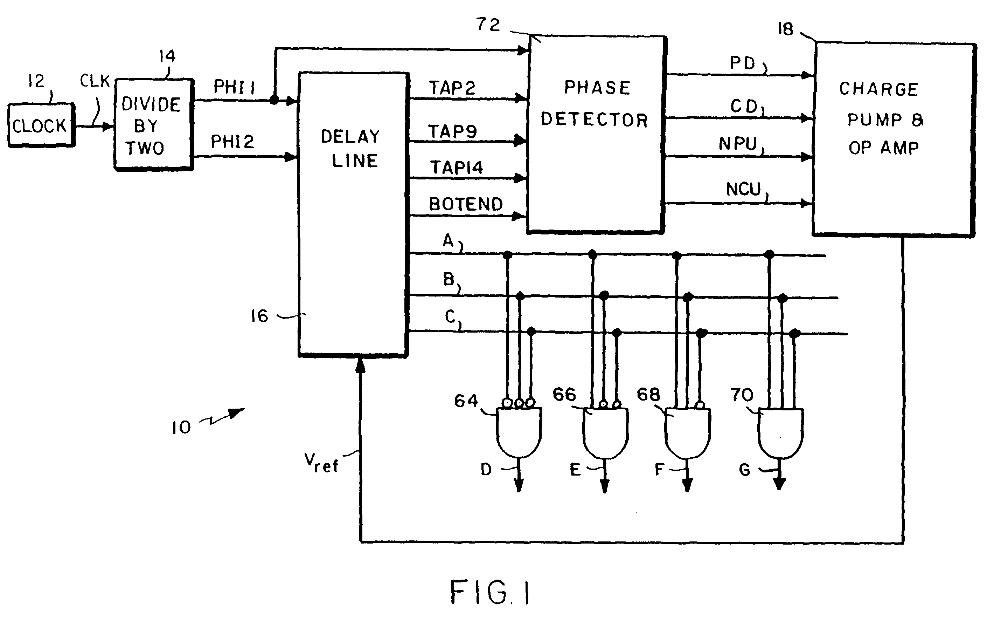

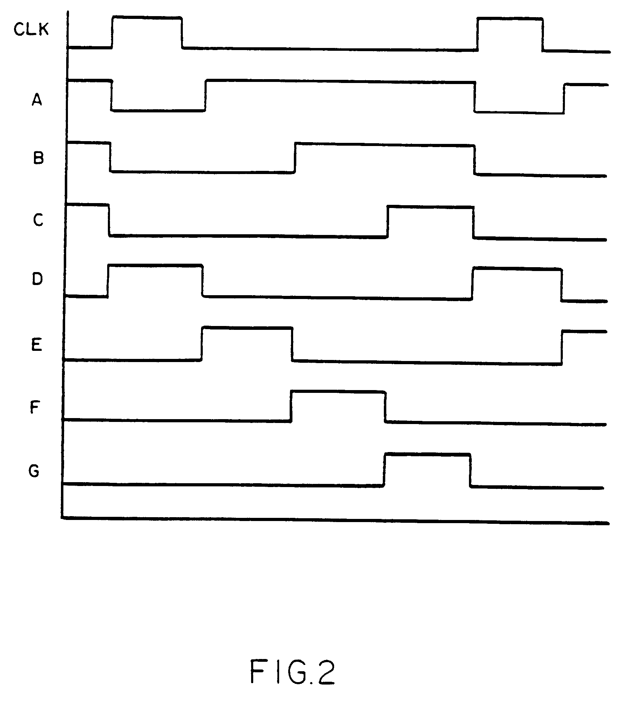

U.S. Patent No. 4,873,491, issued October 10, 1989 to Wilkins, relates to a closed loop variable phase shift circuit utilizing a variable time delay line controlled by feedback provided by a phase detector. The circuit employs feedback control to adjust the delay of the time delay line to achieve the desired phase shift. However, for all of Wilkins' apparently disclosed embodiments (FIGs. 1-4), the phase detector 20 or 100 only receives a single phase shifted input signal Eo from delay line 10 or shift register 90, on a single input line 23 or 103, respectively. Phase detector 20 or 100 also receives an unshifted input signal Ei, directly and not from delay line 10 or shift register 90. Furthermore, Wilkins appears to teach, at column 4, lines 35-50 referring to his Fig. 2, use of a switch 80 and voltage source V to initialize the circuit of FIG. 2. This initialization is used to specify the minimum delay value, and to avoid unwanted phase shifts of the desired phase shift plus some integral multiple of 360°. Thus, a preliminary initialization step is required for proper operation.

U.S. Patent No. 4,855,615, issued August 8, 1989 to Humpleman, relates to a switching circuit for selecting between first and second clock signals while seeking to avoid glitches at the instant of switch-over between the two clock signals. When it is desired to switch from the first to the second clock signal, the first clock signal is de-selected in synchronism with the beat of the first clock and then, after a delay, the second clock signal is selected in synchronism with the beat of the second clock. Conversely, when it is desired to switch from the second to the first clock signal, the second clock signal is de-selected in synchronism with the beat of the second clock and then, after a delay, the first clock signal is selected in synchronism with the beat of the first clock. This is intended to avoid the possibility of a short pulse or "glitch" at the instant of switch-over. However, since Humpleman relates to a switching circuit for selecting between first and second clock signals, Humpleman relates to a different problem than that set forth above. Instead, Humpleman appears to be directed to a switching circuit for selecting and switching between one of two running asynchronous clocks, with a control signal, in a manner that is intended to provide a smooth transition while switching between those two clocks.

Furthermore, in both Bazes and in Johnson and Hudson, if there is a user requirement to substantially reduce power consumption, such that the clock input ceases, then once full power is regained and clock operation is restarted, the system must completely restart as if there had been no previous operation of the system. Such reinitialization of the system introduces delays.

U.K. Patent GB 2,112,236 relates to a digital circuit for clock synchronization in which a detected phase difference is stored and then compared with a reference. A feedback arrangement is utilized to synchronize clocks. The apparatus embodying the present invention relates to controlling the phase of a delay line. Japanese Patent Abstract JP 01-61120 relates to phase synchronization of an oscillator rather than phase control of a delay line like the apparatus embodying the present invention.

Those concerned with the development of signal-controlled electrical devices have long recognized the need to conserve power by temporarily restricting operation of such devices, while retaining the value(s) of such control signal(s) for use when full operation is restored. The apparatus embodying the present invention is also capable of fulfilling this need.

An object of the present invention is to provide a phase detector capable of detecting phase errors, in a periodic signal, of integral multiples of 360°, as well as phase errors of less than 360°, when compared with another periodic signal.

According to the present invention, there is provided apparatus for detection of phase errors in a periodic signal as defined in claim 1.

Reference will now be made to the accompanying drawings, in which
Fig. 1 is a block diagram of a feedback controlled synchronous delay line to which the present invention may be applied;
Fig. 2 is a waveform timing diagram for signals that can be received, signals that can be within, and signals that can be produced by the apparatus of Fig. 1;
Fig. 3 is a block diagram of a multiple segment delay line that can be utilized in the apparatus of Fig. 1;
Fig. 4 is one form of a delay line segment that can be utilized in the delay line of Fig. 3;
Fig. 5 shows another form of a delay line segment that can be utilized in the delay line of Fig. 3;
Fig. 6 shows a phase detector according to one embodiment of the present invention that can be utilized in the apparatus of Fig. 1;
Fig. 7 shows an edge detector that can be utilized in the phase detector of Fig. 6;
Fig. 8 shows logic for charge pump input signal generation that can be utilized in the phase detector of Fig. 6;
Fig. 9 is a generic block diagram illustration of a delay line charge pump and unity gain buffer that can be utilized in the apparatus of Fig. 1;
Fig. 10 shows one form of the charge pump and buffer of Fig. 9;
Fig. 11 shows one form of the transparent latch of Fig. 6;
Fig. 12 is a block diagram of an alternative of a feedback controlled synchronous delay line;
Fig. 13 shows a portion of an alternative form of the charge pump, for inclusion in the apparatus of Fig. 12;
Fig. 14 is a block diagram of a portion of still another form of a feedback controlled synchronous delay line;
Fig. 15 is a block diagram of a portion of a controller that can be utilized in the apparatus of Fig. 14;
Fig. 16 is a waveform timing diagram for signals that can be received, signals that can be within, and signals that can be produced by the apparatus of Figs. 14 and 15;
Fig. 17 is a block diagram of a second portion of a controller that can be utilized in the apparatus of Fig. 14;
Fig. 18 is a block diagram of a save and restore component that can be utilized in the apparatus of Fig. 14;
Fig. 19 shows a phase detector embodying the present invention that can be utilized in the apparatus of Fig. 14;
Fig. 20 shows logic for charge pump signal generation that can be utilized in the phase detector of Fig. 19;
Fig. 21 is a generic block diagram illustration of a delay line charge pump, unity gain buffer and multiplexer that can be utilized in the apparatus of Fig. 14;
Fig. 22 shows one form of a delay line charge pump, unity gain buffer and multiplexer of Fig. 21 that can be utilized in the apparatus of Fig. 14;
Fig. 22A shows a portion of the charge pump of Fig. 22;
Fig. 23 shows one form of an operational amplifier reference component that can be utilized in the apparatus of Fig. 22;
Fig. 24 shows one form of a multiplexer that can be utilized in the apparatus of Fig. 22;
Fig. 25 shows one form of a comparator that can be utilized in the apparatus of Fig. 14;
Fig. 26 shows one form of a change detector that can be utilized in the apparatus of Fig. 14;
Fig. 27 is a block diagram of another form of a feedback control system using a save and restore component to allow power reduction; and
Fig. 28 shows another form of a control system using a save and restore component to allow power reduction.

Referring now to the drawings, wherein like reference characters designate like or corresponding parts throughout the several views, there is shown in Fig. 1 a synchronous delay line 10 utilized as an analog clock signal generator, and receiving a clock signal input CLK from clock 12. Clock signal CLK, shown in Fig. 2, is provided to divide-by-two component 14. Divide-by-two component 14 produces two divided clock signals PHI1 and PHI2, each of which is provided to an input of segmented delay line 16. Signals PHI1 and PHI2 are 180° out of phase with each other. Delay line 16 is controlled by reference voltage V_{ref}, which is produced by a charge pump 18 as a feedback control signal, as described below.

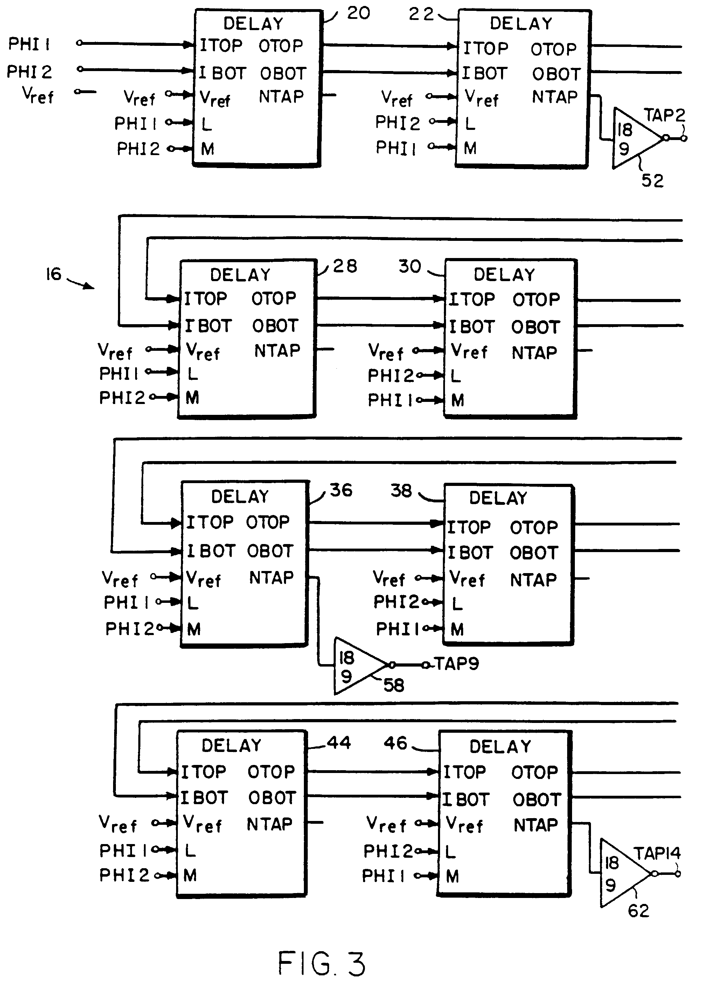

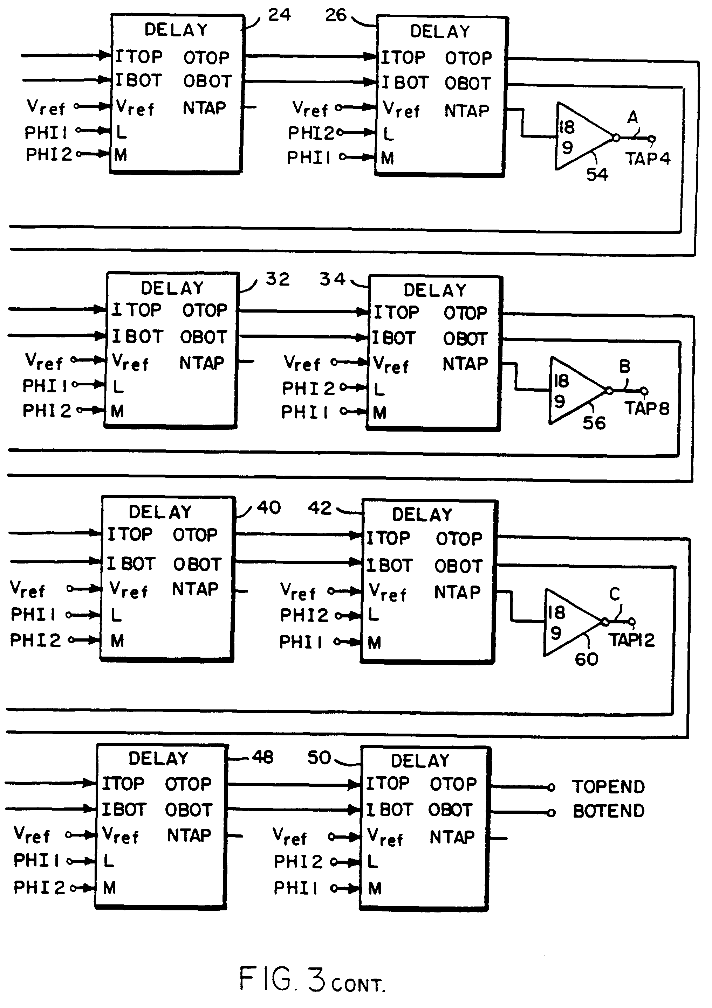

As shown in Fig. 3, delay line 16 includes a plurality of delay line segments 20-50. Each such delay segment has a top signal input ITOP, a top signal output OTOP, a bottom signal input IBOT, a bottom signal output OBOT, and an inverted tap signal output NTAP. Signals PHI1 and PHI2 are applied to inputs L and M (or M and L) of each delay segment, to select which output signal OTOP or OBOT is to be utilized to produce the tap signal at output NTAP. Each such delay segment produces a delay on signals received at the ITOP and IBOT inputs, which delayed signals are respectively produced at the OTOP and OBOT outputs. The value of this delay is controlled by the V_{ref} input of the delay segment.

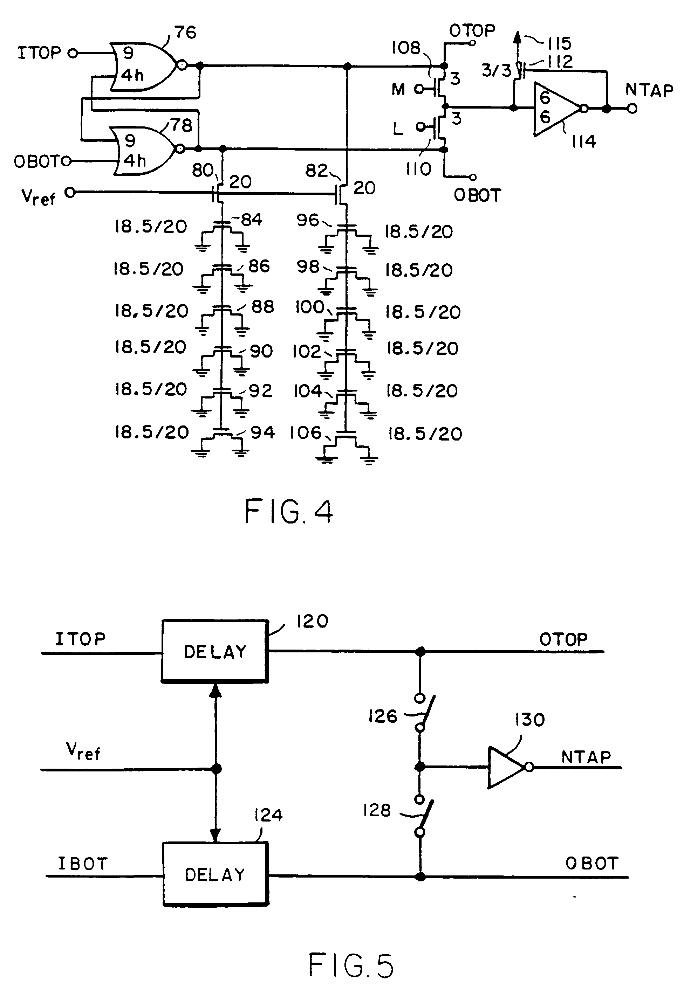

Sixteen delay line segments are illustrated in FIG. 3 because in this embodiment it is desired to obtain four separately phased clock signals D, E, F, and G, as shown in FIG. 2. This is accomplished by obtaining output signals from certain delay line segments, or taps. In each case, the tap output is one of the top OTOP or bottom segment outputs, as selected by the state of the PHI1 and PHI2 signals. As shown in FIGs. 4 and 5, each delay line segment NTAP output produces a signal that has been inverted by inverter 114, so it is necessary to provide an additional respective inverter 52, 54, 56, 58, 60 or 62 at the NTAP output to provide an uninverted tap output signal. Tap signal A is produced by fourth segment 26 and inverter 54. Tap signal B is produced by eighth segment 34 and inverter 56. Tap signal C is produced by twelfth segment 42 and inverter 60. As shown in FIG. 2, where a clock signal CLK is provided, and it is desired to obtain four equal phases of that clock signal as output clock signals D, E, F, and G, this can be done by producing tap signals A, B, and C, each derived from the original clock input signal CLK. As shown in FIG. 1, clock output signals D, E, F, and G can be obtained by appropriately combining signals A, B, and C combinatorially. For example, this can be accomplished utilizing logic gates 64, 66, 68, and 70. Signal D is the inverse of signal A ANDed with the inverse of signal B ANDed with the inverse of signal C. Signal E is signal A ANDed with the inverse of signal B AND the inverse of signal C. Signal F is signal A ANDed with signal B ANDed with the inverse of signal C. Signal G is signal A ANDed with signal B ANDed with signal C. Alternatively, for the tap signals A, B, and C shown in FIG. 2, signal C need not be utilized for generation of output signals D and E, while signal C alone could determine output signal G, and tap signal A need not be utilized for generation of output signal F. Additional desired outputs may require additional taps.

As shown in FIG. 1, delay line 16 generates four other signals which are supplied only to phase detector 72. These are a tap signal TAP2 from second delay segment 22, a tap signal TAP9 from ninth delay segment 36, a tap signal TAP14 from fourteenth delay segment 46, and the output signal BOTEND from sixteenth delay segment 50. Phase detector 72 examines these signals for any phase or frequency error, and generates control signals PD, CD, NPU, and NCU to control delay line 16 and adjust the phase or delay. More specifically, output signals PD, CD, NPU, and NCU are provided to charge pump 18, which in response produces voltage control signal V_{ref}. Voltage control signal V_{ref}, which is provided to each segment 20-50 of delay line 16, controls the total delay through delay line 16.

As shown in FIGs. 3 and 4, each delay line segment 20-50 has two signal inputs ITOP and IBOT (top input and bottom input, respectively), and produces two delayed output signals OTOP and OBOT (top output and bottom output, respectively). As shown in FIG. 4, the two output signals OTOP and OBOT can be produced by two crossed NOR gates 76 and 78. As shown in FIG. 4, control voltage input V_{ref} is applied to FETs (Field Effect Transistors) 80 and 82, which act as variable resistors. The source of FET 80 is connected to the output of NOR gate 78, while the source of FET 82 is connected to the output of NOR gate 76. Each of FETs 84-106 has its drain and source connected together, for example to ground. The gate of each of FETs 84-94 is connected to the drain of FET 80 while the gate of each of FETs 96-106 is connected to the drain of FET 82. Accordingly, FETs 84-106 act as capacitors between ground and the drains of FETs 80 and 82, respectively. In this manner, control voltage V_{ref} controls the speed of operation, and thus the delay provided by, each delay line segment 20-50. In FIG. 4, V_{ref} does so by controlling the resistances provided by FETs 80 and 82. Varying the resistance of the MOSFETs 80 and 82 varies the effective amount of capacitive loading from MOSFETs 84-94 and 96-106 respectively seen by NOR gates 76 and 78, thus controlling the delay. Increasing this resistance decreases the effective capacitive loading on NOR gates 76 and 78, thereby increasing speed of operation of the NOR gates, and decreasing the delay provided by the delay line segment.

Two other inputs to each segment 20-50 are signals PHI1 and PHI2. As shown in FIG. 2, these signals are provided alternately to inputs L and M, or M and L, of each delay line segment 20-50. In FIG. 4, the signal applied to input M is applied to the gate of FET 108, while the signal applied to input L is applied to the gate of FET 110. Since signal PHI1 is high when signal PHI2 is low and vice versa, only one of FETs 108 and 110 will be switched on at any time. Signals PHI1 and PHI2 if applied in the active state to FET 108 or FET 110 would turn that FET on. If FET 108 is turned on, then segment output signal OTOP is inverted and produced at the NTAP output of the segment. If FET 110 is instead switched on, then output signal OBOT is inverted and provided to the NTAP output of the segment.

The numbers (other than reference numerals) shown by each element in the Figures indicate their size. For example, FET 80 is labeled just with the number 20, which indicates a 20 micron wide transistor with the minimum channel length of 1-1/2 microns and effectively of 0.85 microns. FET 84, which has two numbers, is indicated to be 18-1/2 microns wide and 20 microns long, with a resulting effective length of 20 - (1.5 - 0.85) = 19.35. FETs drawn with an additional diagonal slash in the FET symbol, between drain and source (such as FET 112), are P-channel, while FETs drawn without that additional slash (such as FET 84) are N-channel. Gates are preferably implemented in CMOS. For example, NOR gate 76, which bears characters 9 and 4h, has a 9 micron wide P-channel transistor and a 4.5 micron wide N-channel transistor (the notation 4h meaning 4.5 or four and one-half). As another example, inverter 114, which bears characters 6 and 6, has a 6 micron wide P-channel transistor and a 6 micron wide N-channel transistor. An upwardly pointing arrow (e.g., 115) indicates a connection to supply voltage. A downwardly pointing unfilled triangle indicates a connection to ground. The particular component sizes are shown by way of example only; the invention is not to be construed as being limited thereto.

Alternatively, as shown in FIG. 5, a delay line segment can comprise any sort of voltage controlled delay 120 and 124, each controlled by an appropriate reference signal such as the common signal V_{ref}. Control switches 126 and 128, respectively controlled by the M and L inputs, are then used to determine which output signal OTOP or OBOT is provided to inverter 130 for the NTAP output. As one example, instead of crossed NOR gates 76 and 78, two pairs of inverters could be used, with each inverter in a pair connected in series, and each pair connected between the ITOP and OTOP, or IBOT and OBOT, ports.

The apparatus illustrated in FIG. 3 provides four-phase output signals. For an eight-phase output system, taps could be taken from each of second segment 22, fourth segment 26, sixth segment 30, eighth segment 34, tenth segment 38, twelfth segment 42, and fourteenth segment 46. Each such tap would then be provided both to logic for generating the output signals (using different logic than logic gates 64, 66, 68, and 70), and to phase detector 72 for detection of phase errors. Also, although sixteen segments are shown in FIG. 3, any number of segments could be used. For example, if four-phase output signals are desired by the user, then the number of delay line segments used could be any integral multiple of four. However, the number of segments to be used would also be determined by the maximum and minimum values for the voltage controlled delays through each delay line 16 segment 20-50. The choice of numbers of segments would be based primarily on the number of output phases desired by the user, and the limits of the individual delay elements or segments.

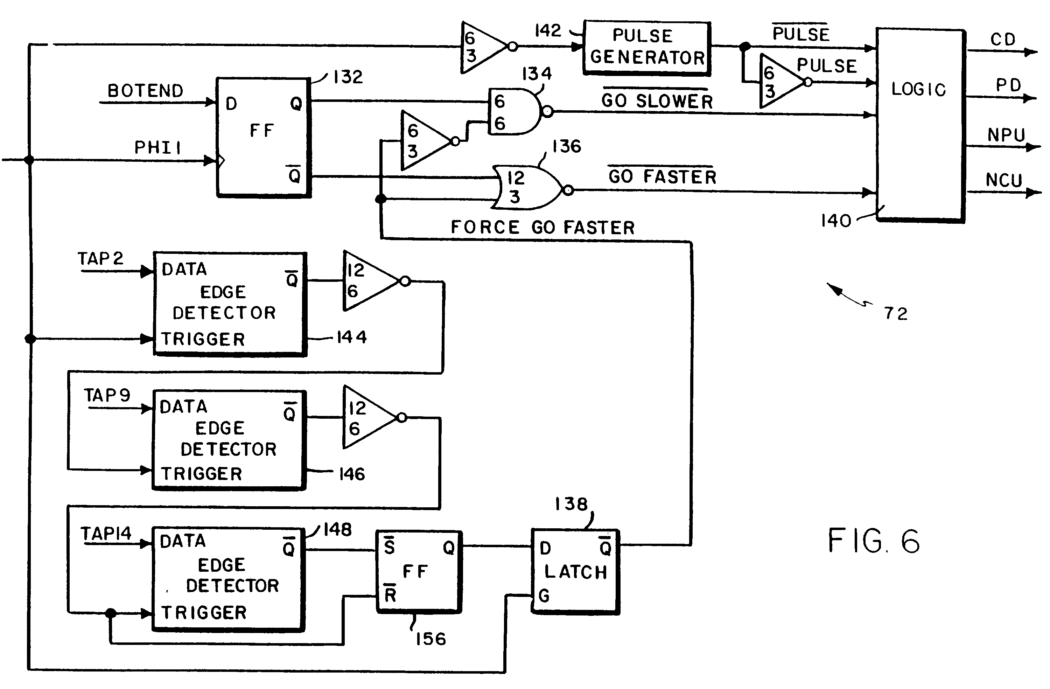

Further detail on phase detector 72 is shown in FIG. 6. Segment 50 output BOTEND and divider output PHI1 are respectively provided to the data and trigger inputs of edge-triggered D-type flip-flop 132. A true signal from the Q output of flip-flop 132, plus a false state for the FORCE GO FASTER signal from latch 138, causes a false-state output from NAND gate 134. The inverted GO SLOWER signal produced by NAND gate 134 is then held true or low. The not-Q output of flip-flop 132 is provided to one input of NOR gate 136. A logic true signal from the not-Q output of flip-flop 132, and/or on the FORCE GO FASTER signal from latch 138, causes a false-state output from NOR gate 136. The inverted GO FASTER signal produced by NOR gate 136 is then held true or low. Accordingly, if a rising edge of divided clock signal PHI1 triggers flip-flop 132 while segment 50 output signal BOTEND is high, then the inverted GO SLOWER signal will be active unless overridden by the FORCE GO FASTER signal from latch 138. Otherwise, the inverted GO FASTER signal will be active. Both the GO SLOWER signal and the GO FASTER signal are provided as inputs to logic 140. Also, an inverted PHI1 signal is provided to pulse generator 142. Pulse generator 142, in response to signal PHI1 becoming low, generates a single negative true output pulse. Pulse generator 142, upon receiving a rising edge, generates a pulse by NANDing the received signal with its delayed inverse. Pulse width is equal to that delay. However, any sort of pulse generator could be utilized as pulse generator 142. That pulse and its inverse are also provided to logic 140. Logic 140 generates appropriate levels for control signals CD, PD, NPU, and NCU, which are then provided to control charge pump 18. In response to on the state of signals CD, PD, NPU, and NCU, charge pump 18 will pump up, pump down, charge up or charge down.

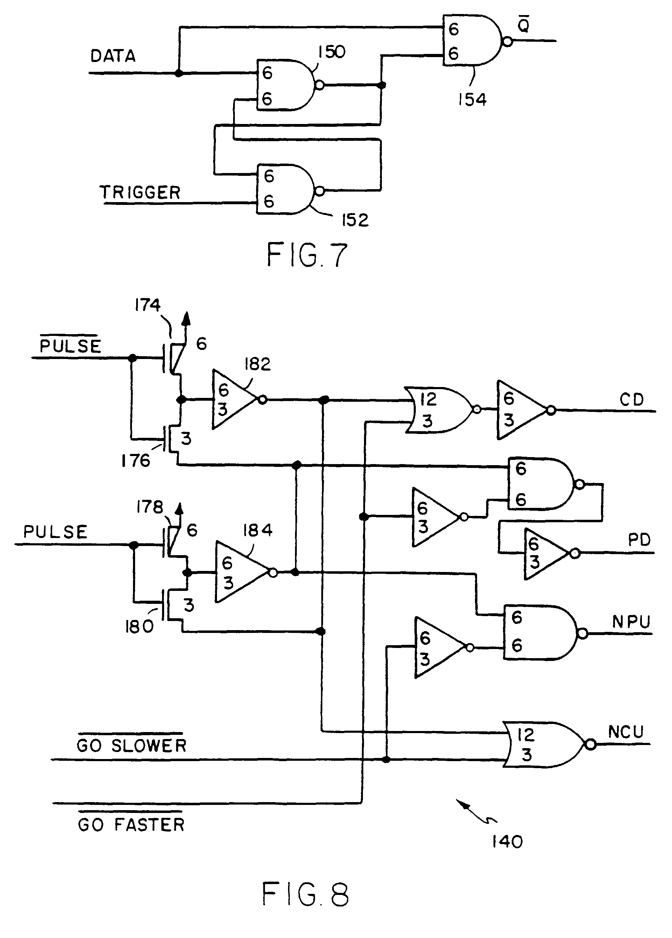

As discussed above, the GO SLOWER signal and the GO FASTER signal state can be controlled, and the output of flip-flop 132 overridden, by inverting transparent latch 138, which generates the FORCE GO FASTER signal. Generation of that signal will now be described. Phase detector 72 also includes rising edge detectors 144, 146, and 148. Each such edge detector 144, 146, and 148 produces a low or true output signal upon detecting a rising edge on a certain signal, unless its trigger input is held low (false). Once such edge detector is shown in FIG. 7. As shown in FIG. 7, two NAND gates 150 and 152 are cross-coupled to in effect form a not-S, not-R single Q output flip-flop. The input signal on which a rising edge is to be detected is applied to one input of NAND gate 150 and to one input of NAND gate 154. A similar arrangement can be utilized as flip-flop 156 of FIG. 6. However, if the trigger signal applied to one input of NAND gate 152 is held low, then no edge of the input signal could be detected by the edge detector of FIG. 7. Alternatively, other edge detectors could be utilized as edge detectors 144, 146, and 148.

Edge detectors 144, 146, and 148 together determine whether a series of rising edges appear in a certain predetermined desired order, as a check on proper operation of segmented delay line 16. For the arrangement of FIG. 6, taps are obtained from three delay line 16 segments, and are checked for proper sequencing of rising edges within delay line 16. As shown in FIG. 3, signal TAP2 is obtained by inverting 52 the NTAP output of second segment 22. Signal TAP9 is obtained by inverting 58 the NTAP output of ninth segment 36. Signal TAP14 is obtained by inverting 62 the NTAP output of fourteenth segment 46. Signal TAP2 is provided as the input signal, and signal PHI1 is provided as the trigger signal, to edge detector 144. Signal TAP9 is provided as the input signal, and an inversion of the output of edge detector 144 is provided as the trigger signal, to edge detector 146. Signal TAP14 is provided as the input signal, and an inversion of the output of edge detector 146 is provided as the trigger signal, to edge detector 148. Accordingly, edge detector 146 will not indicate presence of any rising edge on its input signal TAP9 unless edge detector 144 first detects a rising edge on its input signal TAP2. Similarly, edge detector 148 will not detect any rising edge on its input signal TAP14 unless edge detector 146 first detects a rising edge on its input signal TAP9.

Divided clock signal PHI1 is applied to the G or clock input of transparent latch 138. While signal PHI1 is active (high), the output of latch 138 changes to pass data received. In that condition, the output not-Q of latch 138 is then equal to its data input D. While signal PHI1 is inactive (low), latch 138 holds its previous value, and its output not-Q is unchanged (not-Q=not-Q) notwithstanding whatever may appear at its data input D. This is what is meant by latch 138 being "transparent". The output not-Q of latch 138 is updated to reflect its present data input D only while its clock input G is active or high. Edge detector 144 is triggered by signal PHI1 becoming active. Signal PHI1 becoming inactive closes latch 138. Thus, the output from edge detectors 144, 146 and 148 would not affect the output of latch 138 unless signal PHI1 remains active.

Accordingly, if rising edges are successively detected on signals TAP2, TAP9, and TAP14, in that order, while signal PHI1 remains true or high, then signal FORCE GO FASTER will not be held active. Failure to detect any of these edges, in the above order, indicates presence of a phase error of some odd integral multiple of 360°. To indicate and correct such error condition, signal FORCE GO FASTER is held active or true.

In FIG. 6, edges are detected on taps from second segment 22, ninth segment 36, and fourteenth segment 46. In lieu thereof, taps from any three delay line 16 segments could be utilized, with those taps being checked by corresponding edge detectors of phase detector 72 for rising edges in the order in which their corresponding segments appear in the delay line. However, first segment 20 and last segment 50 cannot be used for this purpose. This is because signal PHI1 is used to trigger first edge detector 144, so that an edge of signal PHI1 could be substantially simultaneous with an edge of a tap from either of these segments. Also, only two taps, and two edge detectors, instead of three could be effectively used for this purpose. Still, use of three (or more) taps and three (or more) edge detectors is preferred. For example, a tap could be obtained from each of fourth segment 26 and fourteenth segment 46. A computer simulation for this arrangement found that errors could be detected up to nine times 360°, but not eleven times and beyond. Also, a computer simulation involving taps from the fourth and eighth segments of a 16-segment delay line found that phase errors could be detected through nine times 360°, but not eleven times or beyond. Computer simulations of taps from the following pairs of segments of a 16-segment delay line were found to not provide detection of errors beyond ten times 360° phase error; 3 and 11, 2 and 13, 2 and 3, 2 and 5, and 2 and 14.

Logic 140 conditions the received pulse, GO SLOWER, and GO FASTER signals to produce control signals CD, PD, NPU, and NCU, such as to avoid overlapping generations, to work with charge pump 18. Logic 140 is shown in greater detail in FIG. 8. Transistors 174, 176, 178 and 180, and inverters 182 and 184, ensure that the inverted and noninverted PULSE signals are nonoverlapping. Thus, charge pump 18 does not charge (to null parasitic capacitance) while pumping (to change control signal V_{ref}).

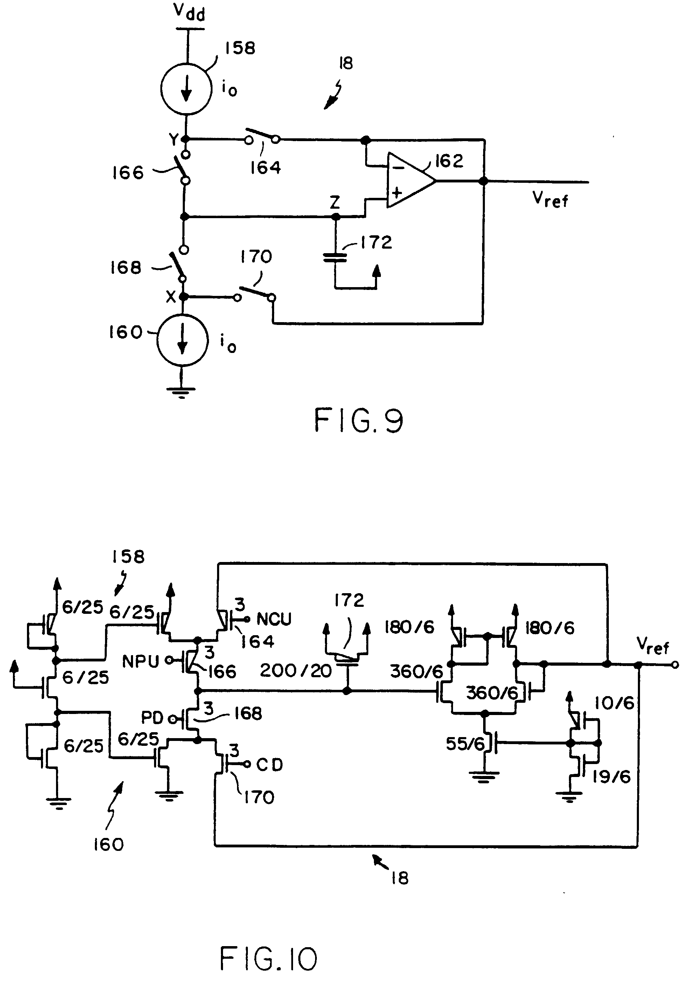

Charge pump 18 is shown in greater detail in FIG. 9. As shown in FIG. 9, charge pump 18 includes matched current sources 158 and 160, operational amplifier 162, and four controlled switches 164, 166, 168, and 170. Amplifier 162 is a simple operational amplifier connected in a unity gain configuration, as shown in FIG. 9. Each current source 158 and 160 produces a current iₒ. Capacitor 172 can be connected between node Z, and supply voltage (as shown in FIGs. 9 and 10) or ground. When negative logic signal NCU is low or active, switch 164 is closed, and any parasitic capacitances in source 158, or elsewhere at node Y, charge to V_{ref}. When negative logic signal NPU is low or active, switch 166 is closed, and charge pump 18 pumps up. This means that the voltage drop across capacitor 172, and control voltage V_{ref}, are increased. When signal PD is high or active, charge pump 18 pumps down. The voltage across capacitor 172, and thus control voltage V_{ref}, are decreased. When signal CD is high or active, switch 170 is closed, charging to V_{ref} any parasitic capacitances in source 160 and elsewhere at node X.

Signals NCU and CD are nonoverlapping complementary signals utilized to null out any parasitic effects in charge pump 18, particularly to discharge and effectively cancel parasitic capacitance of sources 158 and 160, especially when charge pump 18 is not pumping or changing control voltage V_{ref}. Otherwise, stored charge in such parasitic capacitance could charge capacitor 172, causing an erroneous change in control voltage V_{ref}. Johnson and Hudson, supra, at Section VI. at pages 1221-1222 and Fig. 8, discusses the potential for error provided by parasitic capacitance of his current source, to which reference is hereby made. In addition, switches 166 and 168, when respectively implemented as MOS transistors, have parasitic capacitive coupling effects which are also nulled out by precharging nodes X and Y to V_{ref}. This precharging is accomplishing by closing switches 164 and 170.

One implementation of charge pump 18 is shown in FIG. 10.

Control voltage V_{ref} is produced by charge pump 18 to control speed of delay line 16.

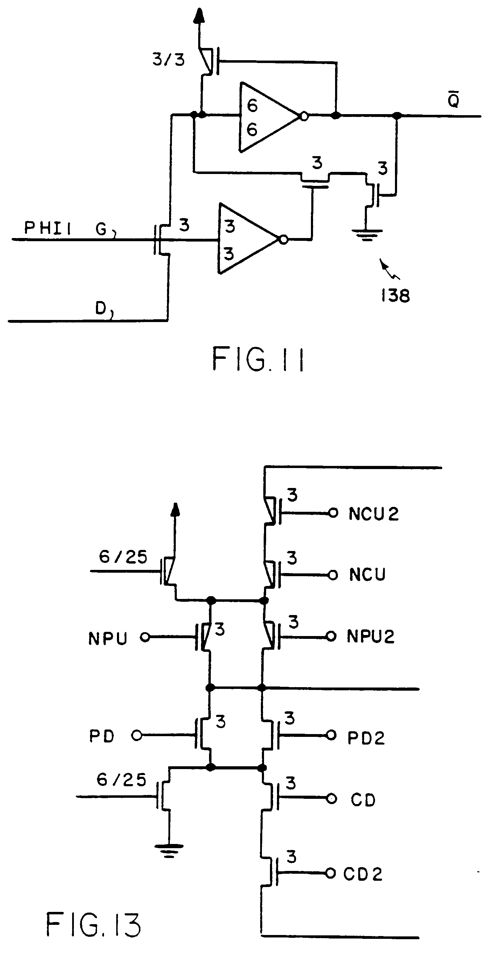

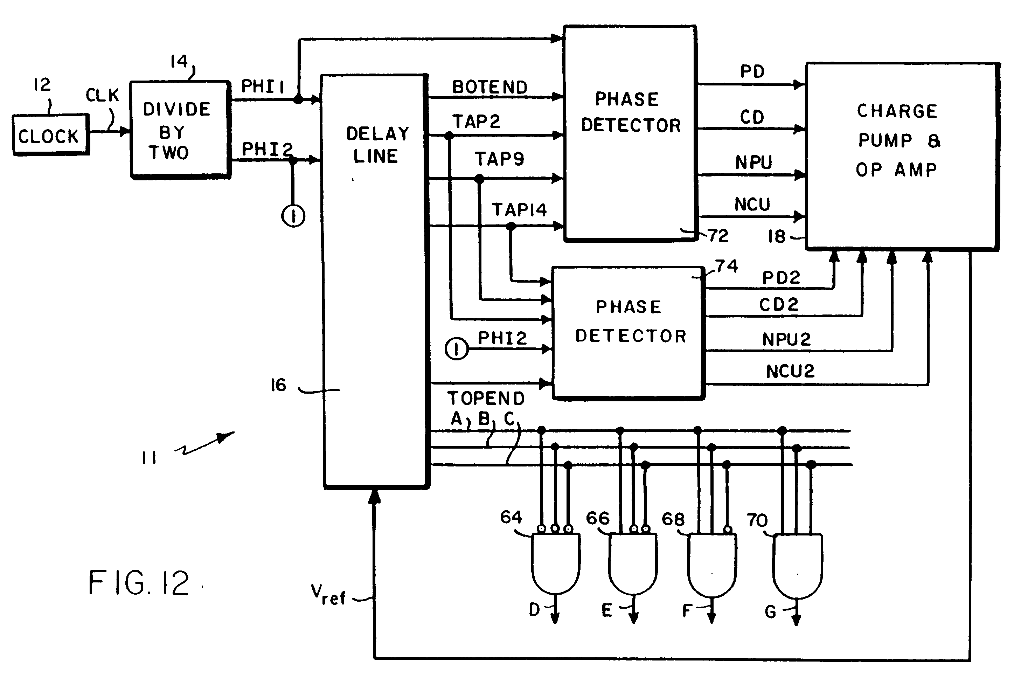

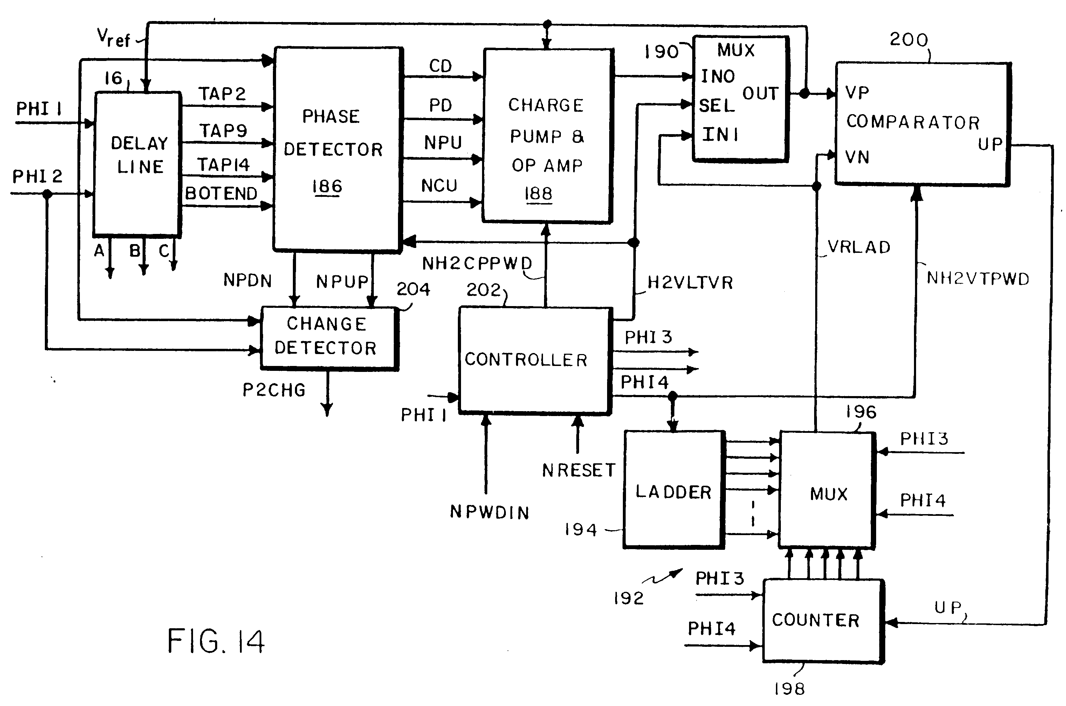

Edge detectors 144, 146, and 148 are particularly intended to address output signal phase errors of odd integral multiples of the period of the original clock signal CLK. Even (as opposed to odd) integral multiples of the period of the clock signal CLK need not be considered by these edge detectors, for the following reason. Divider 14 produces two divided clock signals, PHI1 and PHI2. Both signals PHI1 and PHI2 are received by delay line 16. However, only one of these signals, PHI1, is received by phase detector 72. Accordingly, in effect, only half of delay line 16 (the half utilizing signal PHI1) is actually utilized to produce the various taps used for error detection. However, since phase detector 72 does not receive signal PHI2, phase and frequency error correction can be done every PHI1 cycle, or only about half the time (every other CLK cycle) that phase detector 72 is operating. To avoid this delay, and thus provide faster correction of phase and frequency errors, an additional phase detector 74 can be utilized. An alternative form of synchronous delay line, including additional phase detector 74, is shown in FIG. 12. This additional phase detector 74 would be identical to the phase detector shown in FIGs. 6-8 and 11, except that, as shown in FIG. 12, instead of receiving divided clock signal PHI1, signal PHI2 would be received. Also, instead of receiving output signal BOTEND from the OBOT output of sixteenth delay segment 50, output signal TOPEND from the OTOP output of segment 50 would be received instead by the additional phase detector 74. In addition, as shown in FIG. 13, charge pump 18 would have to be modified to accommodate the additional control signals NCU2, NPU2, PD2, and CD2 produced by the additional phase detector. For each such additional signal, an additional transistor would be added to the charge pump configuration of FIG. 10 to accommodate each such additional signal. The additional transistor receiving NPU2 would be connected in parallel with the existing transistor receiving signal NPU. The additional transistor receiving signal PD2 would also be connected in parallel with the transistor receiving signal PD. The additional transistor receiving signal NCU2 would be connected in series with the transistor receiving signal NCU. The additional transistor receiving signal CD2 would be connected in series with the transistor receiving signal CD. Otherwise, operation of the additional phase detector 74 would be identical to the operation of phase detector 72 described above.

If the incoming clock signal stops, or if the analog component generating reference voltage V_{ref} is shut down, then synchronous delay line 10 will cease operation. Upon resumption of such operation, there can be relatively significant delay in redetermining the appropriate level of reference voltage V_{ref}. To avoid such delay, in the apparatus of FIG. 14 the value of reference voltage V_{ref} is in effect digitized and stored for use upon resumption of normal operation. Such insertion of a stored value of V_{ref} into the feedback loop reinitiates operation with a value of reference voltage V_{ref} that is reasonably close to the needed value. Such storage and provision of reference voltage V_{ref} is provided by the apparatus of FIGS. 14-28.

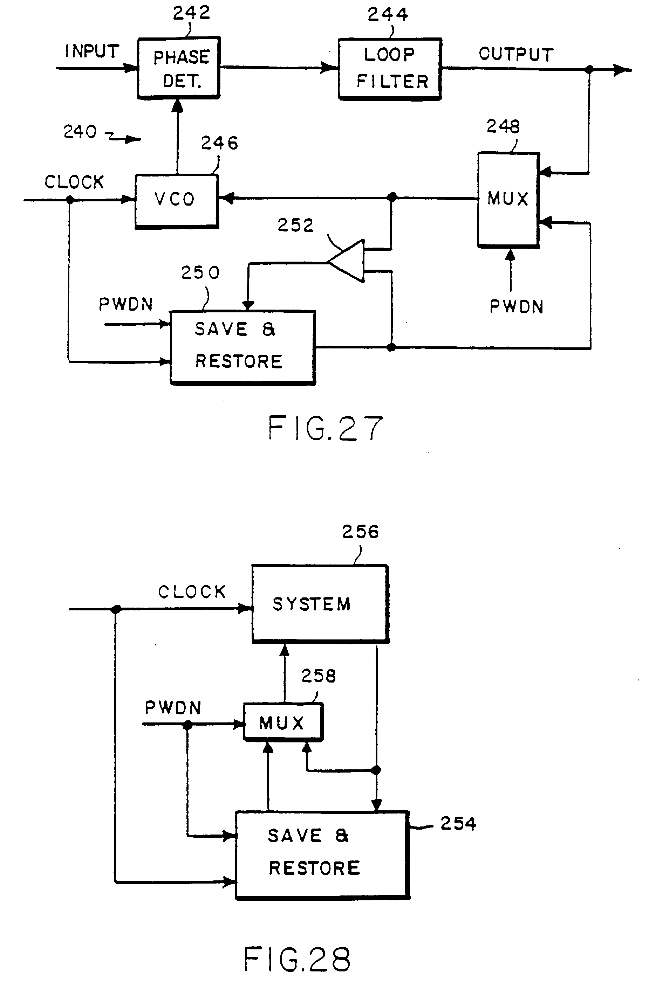

FIG. 14 shows a portion of the synchronous delay line of FIG. 1 with additional structure provided for storage and restoration of the operating value of reference voltage V_{ref}. However, such additional structure could also be utilized in the apparatus of FIG. 12, utilizing either or both of phase detectors 72 and 74. Also, certain portions of the apparatus of FIG. 14 could be utilized to save and restore the feedback control value for any feedback-controlled system, such as the phase locked loop of FIG. 27. Furthermore, as shown in FIG. 28, certain portions of the apparatus of FIG. 14 could be utilized to save and restore the control value for any signal-controlled system, such as the system shown in FIG. 28, even though that system may not be a feedback-controlled system. Certain portions of the apparatus of FIG. 14 could also be utilized in the above-described systems of Bazes and of Johnson and Hudson. However, for purposes of the following discussion, it will be considered that the structure of FIG. 14 forms part of the apparatus of FIG. 1.

In FIG. 14, divided clock signals PHI1 and PHI2 are provided to delay line 16, which also receives reference voltage V_{ref}. Tap signals TAP2, TAP9, and TAP14, respectively produced by second delay unit 22, ninth delay unit 36 and fourteenth delay unit 46, are produced by delay line 16 and provided to phase detector 186. Output bottom signal OBOT from delay unit 50 is also provided to phase detector 186 as signal BOTEND. Phase detector 186 also receives divided clock signal PHI1. In response to those signals, phase detector 186 provides control signals PD, CD, NPU, and NCU to charge pump and operational amplifier 188. Operation of phase detector 186 is similar to that of phase detector 72 of FIG. 1. Operation of charge pump and op amp 188 is similar to that of charge pump and op amp 18 of FIG. 1. In each case, differences are discussed below. During normal operation, the signal produced by charge pump and op amp 188 would be utilized as reference voltage V_{ref}. That output signal is provided to two-to-one multiplexer 190. The output of multiplexer 190 provides reference voltage V_{ref} as feedback control to delay line 16 and to charge pump and op amp 188.

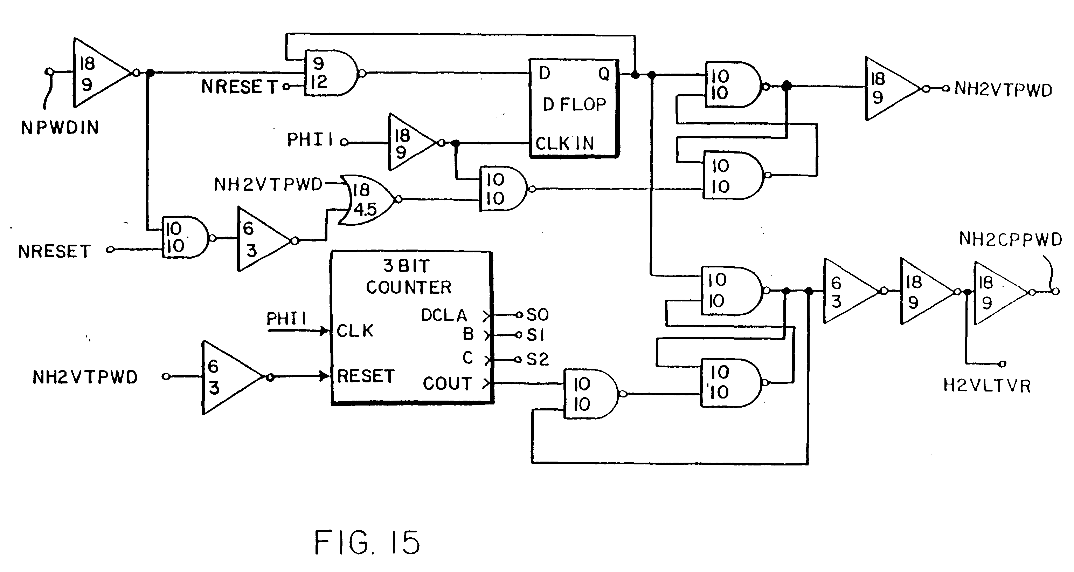

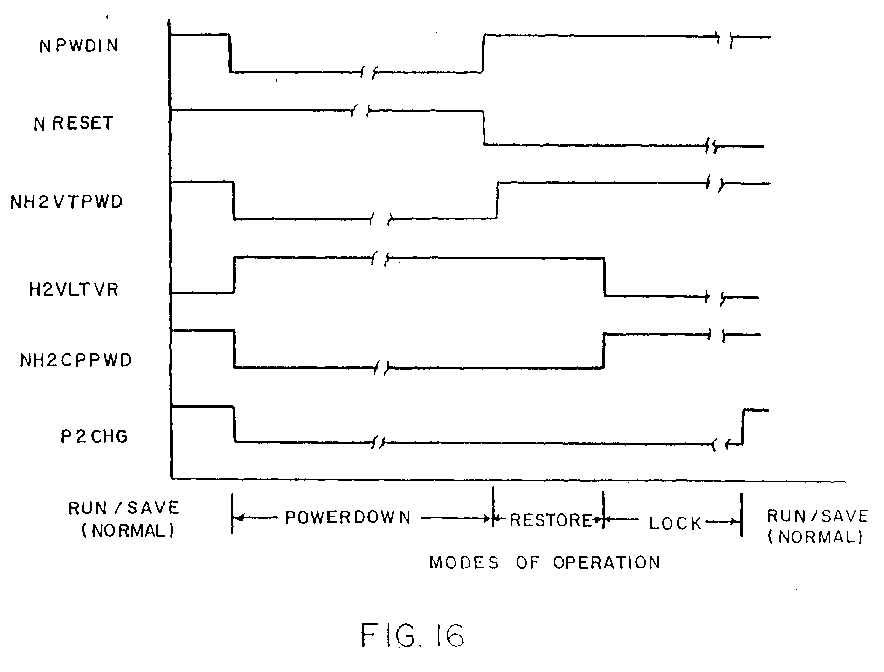

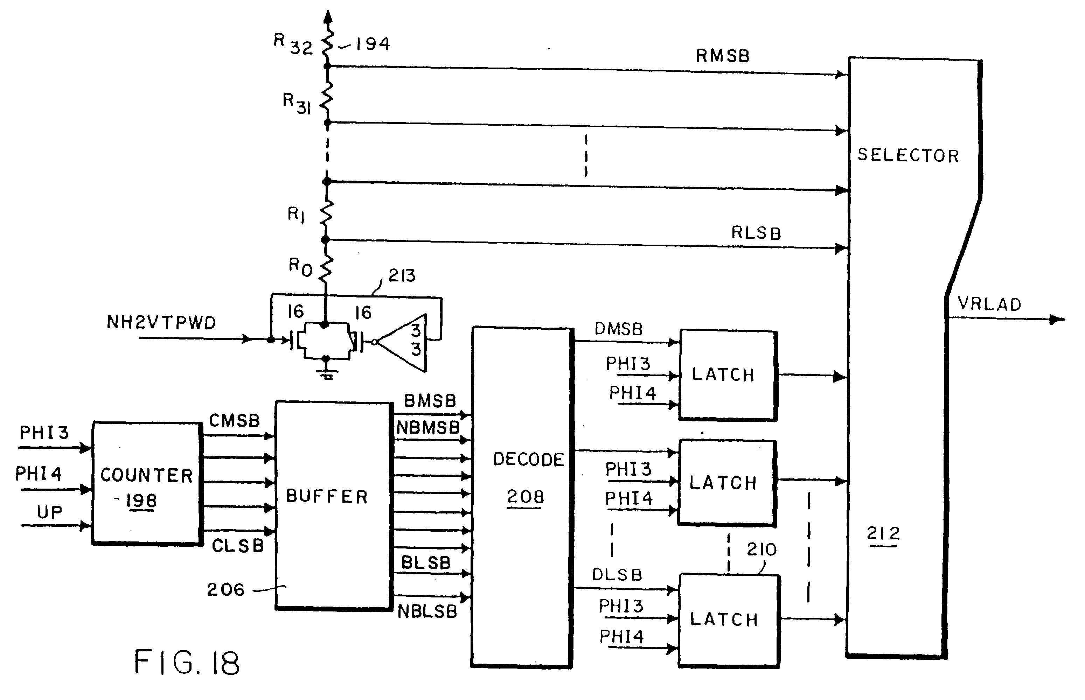

The apparatus of FIG. 14 also includes save/restore component 192. Save/restore component 192 includes resistor ladder 194, multiplexer 196 receiving the divided signals from resistor ladder 194, counter 198 controlling multiplexer 196, comparator 200 controlling counter 198, and controller 202 controlling multiplexer 190, resistor ladder 194, comparator 200 and charge pump and op amp 188. Such control by controller 202 is based on received control signals NPWDIN and NRESET. Input control signals NPWDIN and NRESET respectively indicate whether to enter or exit a low power mode for the system, and whether a system-wide reset which overrides that mode has occurred. In response to input control signals NPWDIN and NRESET, controller 202 produces control signals NH2VTPWD, NH2CPPWD, and H2VLTVR, as shown in Figs. 15 and 16. As can be seen in FIG. 15, signal NH2CPPWD is the inverse of signal H2VLTVR. As shown in FIG. 17, controller 202 also produces clock signals PHI3 and PHI4 in response to divided clock signal PHI1 and control signal NH2CPPWD. However, it is preferred that signal PHI1 be buffered before its provision to the apparatus of FIG. 17.

Comparator 200 is provided with the signals produced by multiplexer 190 and multiplexer 196. If enabled by control signal NH2VTPWD from controller 202, comparator 200 compares the respective output signals of multiplexer 190 and multiplexer 196, and produces comparison signal UP. Signal UP serves as an up/down control signal for counter 198. Signal UP is made high to increment counter 198 when the output of multiplexer 196 has a value less than that of the output of multiplexer 190. Otherwise, counter 198 is decremented. During normal operation, multiplexer 190 would produce the output of charge pump and op amp 188 as reference voltage V_{ref}. Clock signals PHI3 and PHI4 received by counter 198 determine the frequency of such update of counter 198. Counter 198 determines which input to multiplexer 196 appears on the output of that multiplexer. A change in the value of counter 198 results in a change in the selected input to multiplexer 196. In the apparatus of FIG. 14, incrementing counter 198 causes multiplexer 196 to change its selection of resistor ladder 194 output lines to an output line with an increased value, and decrementing the counter likewise would cause selection of a decreased value. Alternatively, a larger count value of counter 198 could cause selection of a lower resistor ladder 194 output value. During the low power mode and also when restoring the reference voltage V_{ref} while recovering from the low power mode, comparator 200 is disabled by signal NH2VTPWD from controller 202, since the value of reference voltage V_{ref} is not reliable and no comparisons are necessary. Thus, no power is wasted in comparator 200 when the apparatus is in low power mode. Initially during reduced power mode or loss of the incoming clock signal CLK, resistor ladder 194 would be disabled by a CMOS switch 213 controlled by signal NH2VTPWD from controller 202, for the same reason. During recovery from the low power mode, multiplexer 190 would pass through the output signal VRLAD of multiplexer 196 as reference voltage V_{ref}, thus restoring reference voltage V_{ref} to its saved value, since charge pump and op amp 188 would not then have a reliable output for that purpose. However, as shown in FIG. 16, the rising edge of signal NH2VTPWD occurs before that of signal NH2CPPWD, so that ladder 194 is re-enabled while charge pump and op amp 188 is disabled and multiplexer 190 selects the ladder output. Therefore, during the time between a rising edge of signal NH2VTPWD and the successive rising edge of signal NH2CPPWD, the ladder 194 output signal VRLAD from multiplexer 196 is selected by multiplexer 190, and comparator 200 generates signal UP to adjust counter 198. However, signal UP does not yet increment nor decrement counter 198, because clock signals PHI3 and PHI4 are still disabled by signal NH2CPPWD, as shown in FIG. 17. Any voltage or current divider could be utilized in lieu of resistor ladder 194.

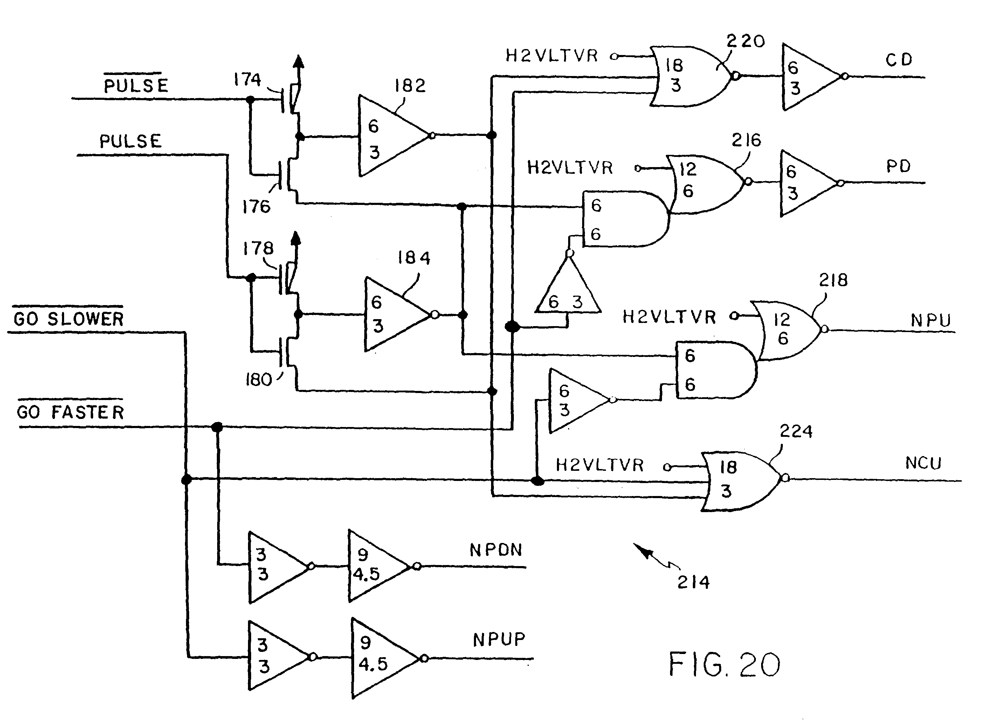

Change detector 204 receives from phase detector 186 signals NPDN and NPUP. As shown in FIG. 20, signal NPDN corresponds to signal GO FASTER, while NPUP corresponds to signal GO SLOWER, each with buffering. When signal GO FASTER and signal GO SLOWER have each changed, this indicates that the apparatus of FIG. 14 has recovered from a power down mode, and locked to the incoming clock signal CLK. Such recovery would be reflected in signal P2CHG produced by change detector 204.

Relative timing of certain of the above-described control signals is illustrated by FIG. 16. Power down mode is entered with a falling edge of signal NPWDIN. A falling edge of signal NH2VTPWD, a falling edge of signal NH2CPPWD (and thus a rising edge of signal H2VLTVR) and a falling edge of signal PH2CHG, preferably occur 1 clock signal CLK cycle thereafter. Power reduced mode is exited with a rising edge of signal NPWDIN or a falling edge of signal NRESET. A rising edge of signal NH2VTPWD, indicating a full power condition, preferably occurs 1 clock signal CLK cycle after a rising edge of NPWDIN or a falling edge of signal NRESET, whichever occurs first after a falling edge of signal NPWDIN. A rising edge of signal NH2CPPWD (and thus a falling edge of signal H2VLTVR) preferably occurs 8 clock signal CLK cycles after such a rising edge of signal NH2VTPWD. The number of 8 cycles is selected for complete re-enabling and settling of resistor ladder 194 after the rising edge of signal NH2VTPWD; this number may vary with the requirements of the particular ladder or other divider used. In this embodiment, a rising edge of signal P2CHG occurs from 16 to 200 clock signal CLK cycles after that rising edge of signal NH2VTPWD, depending on how accurate the saved value of reference voltage V_{ref} is and how long it takes delay line 10 to lock. However, the foregoing numbers of cycles are preferred for this embodiment, and can be altered as needed.

Save/restore component 192 is shown in greater detail in FIG. 18. Although resistor ladder 194 is shown here as a 32 step resistor ladder having 32 output lines, and although counter 198 is accordingly here shown as a 5-bit binary counter (2⁵ = 32), these values are merely illustrative, and the invention is not to be construed as being limited thereto. Counter 198 is a 5-bit binary up/down counter, clocked by clock signals PHI3 and PHI4, and incremented or decremented once each such clock cycle according to the state of up/down signal UP. Counter 198 can for example include four full adders and five clocked D-type latches or flip-flop, with each such latch or flip-flop producing one of the five parallel output bits. The latch producing the least significant bit would then receive, as its data input, its own output inverted. One of the full adders would then be utilized for each of the remaining four count bits, with the adder for the most significant bit not having a carryout, and with the sum output of each such full adder being provided to the data input of the data latch for the corresponding count bit. The inverse of signal UP would be provided as one addend input to each of the full adders, with the other addend being provided by the corresponding count bit output of the corresponding data latch, and the carry input being provided by the carry output of the full adder for the next lower significant bit. The carry input for the full adder for the next-to-least significant bit would be provided by the output for the least significant bit. However, any conventional 5-bit binary up/down counter could be utilized as counter 198.

Resistor ladder 194 includes, for 32 outputs, a string of 33 resistors R₃₂-R₀ connected in series, with an output being provided at the connection between each adjacent pair of resistors in that string. One end of the resistor string would be connected to the supply voltage. Connected between the other end of the string and ground is a CMOS switch 213 controlled by signal NH2VTPWD. For this embodiment, each of the 33 resistors has the same resistance, to provide equally spaced successive steps between the 32 outputs. However, any number of resistors, with regular or uneven resistance spacing between the lines, could be used in resistor ladder 194. Furthermore, any voltage or current divider could be used in lieu of resistor ladder 194 to produce the desired multiple outputs.

Multiplexer 196 includes buffer 206, 5-to-32 decoder 208, a plurality (here, 32) of clocked transparent latches (one for each decoder output) 208, and a 32-to-1 selector 210 controlled by plurality of latches 208. Buffer 206 amplifies the count bit outputs of counter 198 for easier utilization by the rest of multiplexer 196. Buffer 206 receives the binary count signals from counter 198. Decoder 208 receives the buffered count signals from buffer 206 and decodes the binary coded count signals into individual lines, with only the single line indicated by the binary count being held active. Decoder 208 thereby decodes the five binary coded count bits into 32 control lines. One could expand this code to six bits to control up to 64 control lines, or instead use four bits to control up to 16 control lines, etc. The values of these 32 control lines are retained by clocked plurality of latches 210. Preferably, one latch is provided for each output line of decoder 208. However, any multiple-bit register could be used in place of the plurality of latches 210. Because latches 210 and counter 198 have a common clock, latches 210 are updated each time that counter 198 is updated. Latches 210 only change value (assuming an output value change of counter 198) when clock signal PHI4 is high. Transparent latches 210 are utilized to deglitch the decoder 208, and delay the 32-bit output to the proper phase of the clock because it is desired to have the output change every time signal PHI4 rises to avoid glitches. Since only one of the parallel signals produced by decoder 208 is high or active, only one of the latches 210 outputs are active. For example, buffer 206 can produce a buffered true and a buffered inverted output for each of the counter 198 outputs, and decoder 208 can include 32 5-input NAND gates with inverted outputs, with each of the NAND inputs being connected to a corresponding one of the buffered counter outputs, either inverted or noninverted, depending on the decoded value to be represented by the output of the particular NAND gate. For example, for the LSB NAND gate, each of the buffer counter inputs to the NAND gate would be inverted, while for the MSB NAND gate each of the inputs to that NAND gate would be uninverted.

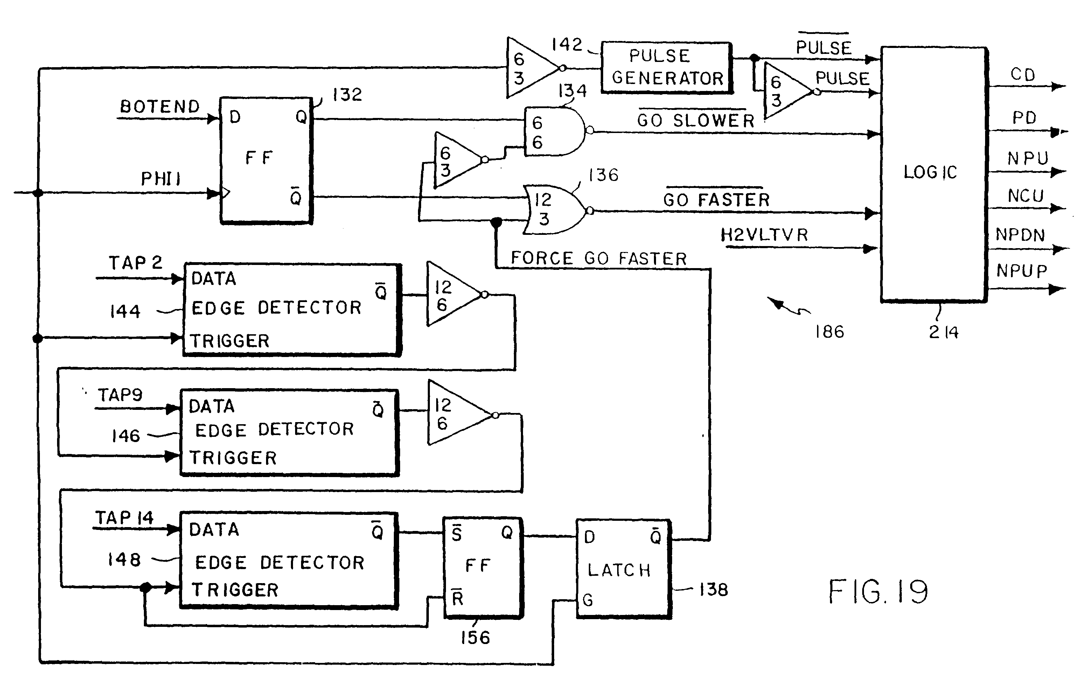

Phase detector 186 of FIG. 14 is illustrated in greater detail in FIG. 19. As can be seen from a comparison of FIGs. 6 and 19, phase detector 72 and phase detector 186 are identical in structure and in operation, with the following exception. While phase detector 72 of FIG. 6 includes logic 140 generating signals CD, PD, NPU and NCU, phase detector 186 of FIG. 19 includes, at a corresponding location, logic 214 receiving signal H2VLTVR and generating signals CD, PD, NPU, NCU, NPDN and NPUP. Logic 214 is shown in greater detail in FIG. 20. As can be seen from a comparison of logic 140 of FIG. 8 and logic 214 of FIG. 20, many similarities in structure and operation are evident. However, logic 214 is provided with two additional NOR gates 216 and 218 so that signal H2VLTVR can be applied to the signal PD and signal NPU outputs. Signal H2VLTVR is applied to the signal CD and signal NCU outputs by providing an additional input to the corresponding NOR gates 220 and 224 for those signals. The practical effect of this introduction of signal H2VLTVR in logic 214 is that, during partial shutdown, that signal will be high. A high signal applied to an input of each of NOR gates 216, 218, 220 and 224 will close those gates to each produce a low signal. As a result, during partial shutdown, signals CD and PD will be held high, and negative logic signals NPU and NCU will be held low. In charge pump and op amp 188, switches 164, 166, 168 and 170 will thereby be held closed, effectively disabling charge pump and op amp 188 during partial shutdown and restoration of reference voltage V_{ref}. This also forces the storage capacitor 172 to be restored to the stored value of reference voltage V_{ref}. During normal operation, signal H2VLTVR is low, and so would not affect the output of any of NOR gates 216, 218, 220 and 224, so that signals CD, PD, NPU and NCU would not be affected.

Also, logic 214 generates signals NPDN and NPUP. As can be seen from FIG. 20, signal NPDN is a buffered form of signal GO FASTER, while signal NPUP is a buffered form of signal GO SLOWER. Signals NPDN, NPUP, PHI1 and PHI2 are provided to change detector 204.

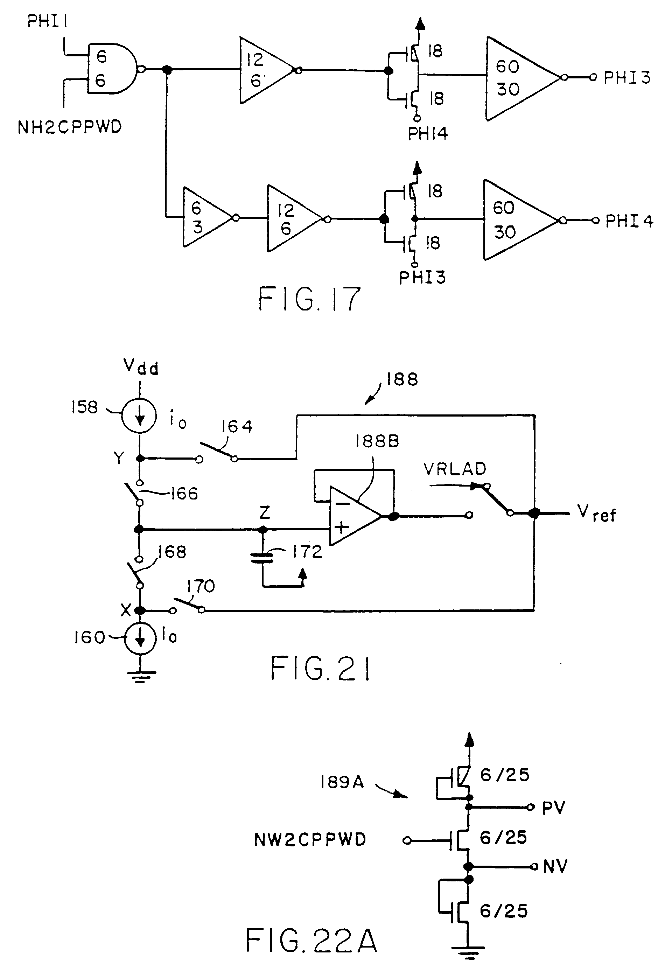

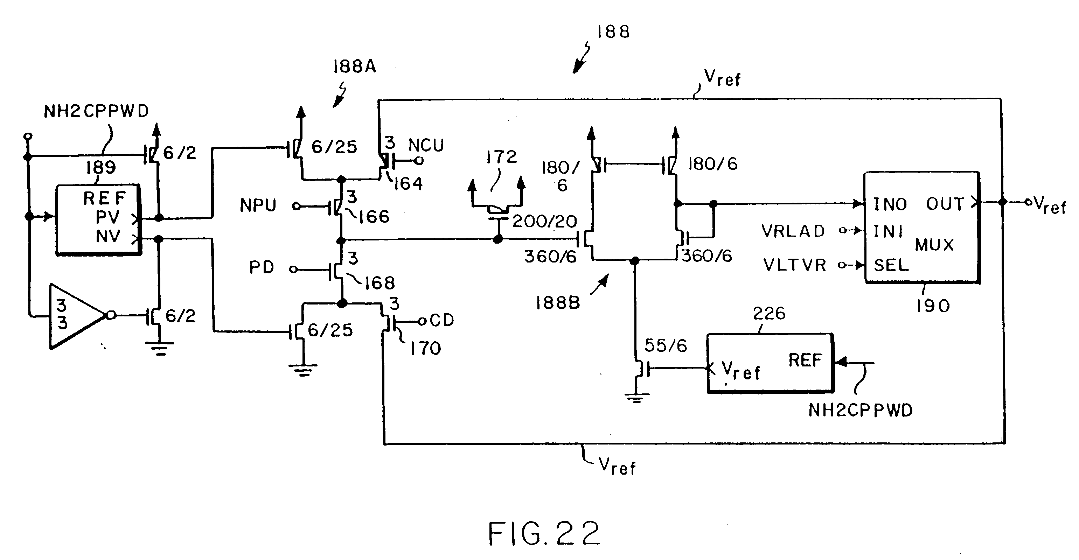

Charge pump and op amp 188, and multiplexer 190, are illustrated generically in FIG. 21. For simplicity of illustration, introduction of control signal NH2CPPWD to charge pump and op amp 188 is not illustrated, although same is shown in corresponding FIGs. 14 and 22. As can be seen from a comparison of FIGs. 9 and 21, structure and operation of charge pump and op amp 18 and charge pump and op amp 188 are similar, except as follows. Charge pump and op amp 188 can be shut down by operation of control signal NH2CPPWD. Also, the feedback of reference voltage V_{ref} in charge pump and op amp 188 now takes place via multiplexer 190, and not directly. Multiplexer 190 is inserted in this feedback loop at the output of charge pump and op amp 188 to determine whether the output of charge pump and op amp 188, or of multiplexer 196, is to be utilized as reference voltage V_{ref}. Switches 164, 166, 168 and 170 operate in FIG. 21 as in FIG. 9, except that, as discussed above, signal H2VLTVR applied to logic 214 can cause all four switches to close during partial shutdown and the restore operation.

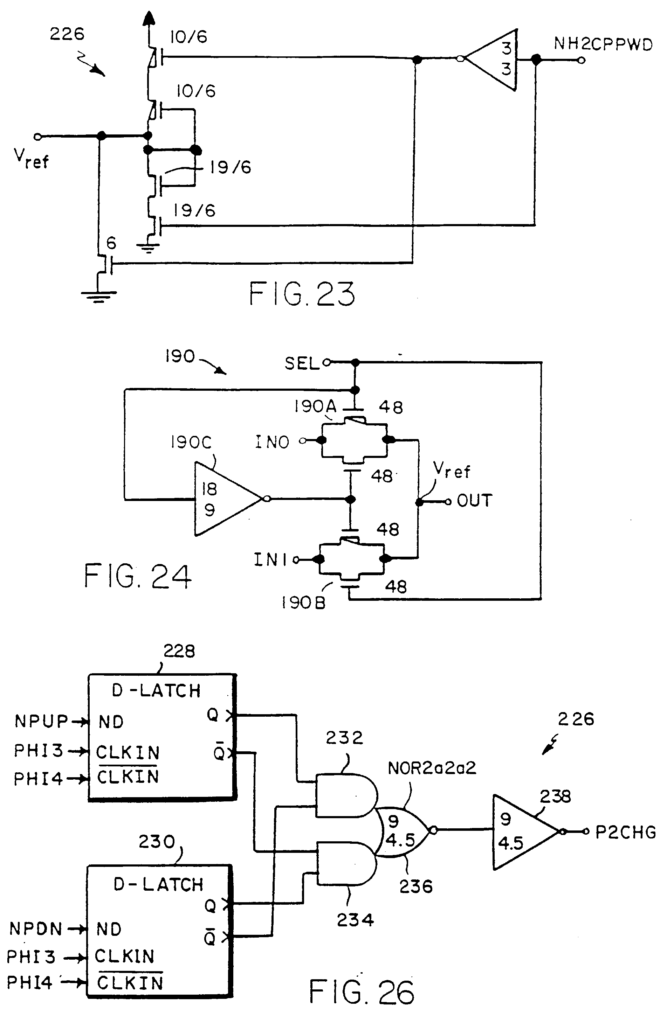

One embodiment of charge pump and op amp 188, and of multiplexer 190, is shown in greater detail in FIG. 22. Charge pump and op amp 188 includes charge pump 188A and unity-gain operational amplifier 188B. Differences of FIG. 22 from FIG. 10 (some of which are discussed above) include introduction of signal NH2CPPWD to control the current reference, and the operational amplifier reference 226, of charge pump and op amp 188; modification of the reference portion of the operational amplifier and of the left side of the charge pump largely to accommodate that control signal; and inclusion of multiplexer 190 at the output of charge pump and op amp 188. The left side of the charge pump 188A of FIG. 22 includes a current reference 189. Current reference 189 includes, for improved stability, preferably ten of current reference 189A shown in FIG. 22A. Otherwise, structure and operation of the structure of FIG. 22 is substantially similar to that of FIG. 10. Operational amplifier reference 226 is shown in greater detail in FIG. 23. Multiplexer 190 is shown in greater detail in FIG. 24. As shown in FIG. 24, multiplexer 190 includes CMOS switch 190A, CMOS switch 190B and buffer 190C. However, any other type of two-throw switch or two-to-one multiplexer could be utilized as multiplexer 190.

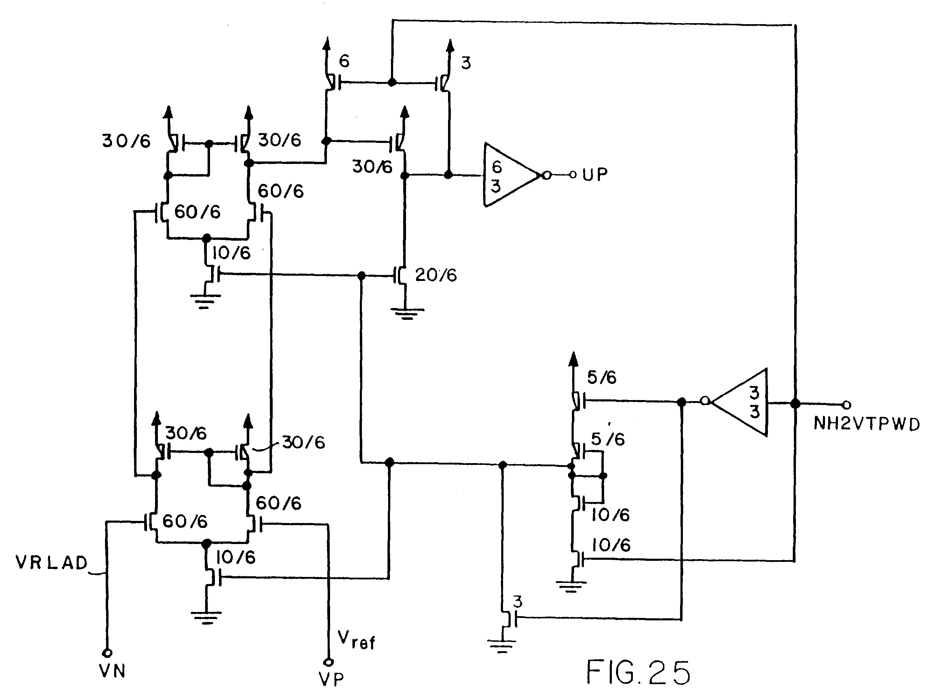

One embodiment of comparator 200 is shown in greater detail in FIG. 25. Positive and negative input terminals are respectively identified as vp and vn. The inverted output terminal produces signal UP.

One embodiment of change detector 204 is shown in greater detail in FIG. 26. As shown in FIG. 26, reference 226 includes two clocked D-type latches or D-type flipflops each producing a Q output and a not-Q output. The outputs of latches 228 and 230 are provided to the inputs of AND gates 232 and 234, whose outputs are provided to the respective inputs of NOR gate 236. The output of NOR gate 236 is inverted and buffered by inverter 238 to produce signal P2CHG.

Although in the foregoing discussion an embodiment of the present invention for use with synchronous delay line 10 is disclosed, the the present invention is not limited to utilization with a synchronous delay line. For example, as shown in FIG. 27, the present invention can be utilized with a phase-locked loop 240. Phase-locked loops and their operation are described in greater detail in Gardner, F.M., Phaselock Techniques, 2nd ed. (John Wiley & Sons, New York, 1979), which is hereby incorporated by reference. Phase-locked loop 240 includes phase detector 242, loop filter 244 and voltage-controlled oscillator 246. The input signal is provided to phase detector 242, which compares that signal with the reference signal provided to the phase detector by VCO 246. Alternatively, a mixer or multiplier may be used in place of phase detector 242. Also, loop filter 244 is a generic representation of any sort of electrical apparatus, which can be included in the phase-locked loop 240. Although the output is shown as being provided from loop filter 244, the loop output may be obtained from any portion of loop 240 as desired for the particular application. However, instead of the output of loop filter 244 being provided directly to VCO 246 to control the operation of the VCO, additional apparatus according to the present invention has been provided. Accordingly, multiplexer 248 multiplexes the signals produced by filter 244 and save and restore component 250. The output of multiplexer 248 is provided to VCO 246 and to comparator 252. Comparator 252 is also provided with the output of save and restore component 250. Comparator 252 compares the output of loop filter 244 with the output of save and restore component 250, and provides its output as a control signal to save and restore component 250. Although VCO 246 and save and restore component 250 are shown in FIG. 27 as being commonly clocked, they can alternatively be separately clocked. Multiplexer 248 and save and restore component 250 are controlled by power down signal PWDN. Structure and operation of multiplexer 248, save and restore component 250 and comparator 252 can be similar to that respectively described above for multiplexer 190, save and restore component 192 and comparator 200.

Although FIGs. 14-27 show the present invention as utilized in a feedback-controlled system, the present invention can be utilized in any signal-controlled system, whether or not feedback-controlled. For example, as shown in FIG. 28, save and restore component 254 can store and reproduce a control signal of system 256 via multiplexer 258. Multiplexer 258 determines whether the output of system 256 or the output of save and restore component 254 is to be provided as the control signal for system 256. System 256 can have one or more outputs. As with the system of FIG. 27, system 256 and save and restore component 254 can be commonly clocked or separately clocked. Structure and operation of multiplexer 258 and save and restore component 254 can be similar to that respectively described above for multiplexer 190 and save and restore component 192.

It should be understood that, although FETs are preferred, the present invention can be constructed in similar fashion with similar operation with devices other than those illustrated. For example, the transistors illustrated in the drawings can be N-channel FETs, P-channel FETs, CMOS, or bipolar transistors. The invention can be implemented in CMOS, NMOS, PMOS, bipolar or GaAs. All topologies shown in the drawings are equally valid for alternative transistors. Additionally, the illustrated topologies are useful for a wide range of possible device geometries, e.g., lengths and widths of diffusion regions.

Some of the many advantages of the invention should now be readily apparent. For example, a novel phase detector has been provided which is capable of detecting phase errors, in a periodic signal such as a clock signal, of integral multiples of 360°, as well as phase errors less than 360°, when compared with another periodic signal such as another clock signal from which the first is derived.

## Claims

1. Apparatus (72) for detection of phase errors in a periodic signal (PHI1), characterized by comprising:
a plurality of edge detector means (**144**, **146**, **148**), each of said edge detector means being connected to receive a differently delayed version of the periodic signal (PHI1), for detecting whether an edge of the periodic signal is present in such respective version, wherein one (**144**) of said edge detector means is triggered to perform edge detection by the periodic signal, and each other (**146**, **148**) of said edge detector means is triggered by the output of an edge detector means, said plurality of edge detector means being thereby connected one to another in series; and
first latching means (**138**), triggered by the periodic signal (PHI1) and operatively connected to the output of the last-connected (**148**) of said plurality of edge detector means, for producing an output indicative of the present output of said last-connected of said plurality of edge detector means while said first latching means (**138**) is triggered by the periodic signal, the output being indicative, while said first latching means is not triggered by the periodic signal, of the output of said last-connected (**148**) of said plurality of edge detector means while the periodic signal was last triggering said first latching means,
whereby the output produced by said first latching means (138) is indicative of a phase error unless edges are detected in the respective differently delayed versions of the periodic signal (PHI1) by said plurality of edge detector means in a predetermined sequence while the periodic signal triggers both said plurality of edge detector means and said first latching means.

2. Apparatus as recited in claim 1 further characterized in that said first latching means comprises a transparent latch.

3. Apparatus as recited in claim 1 further characterized in that said plurality of edge detector means comprises at least three edge detector means.

## Patentansprüche

1. Vorrichtung (72) zur Erfassung von Phasenfehlern in einem periodischen Signal (PHI1), gekennzeichnet durch folgende Merkmale:
eine Mehrzahl von Flankenerfassereinrichtungen (144, 146, 148), wobei jede der Flankenerfassereinrichtungen verbunden ist, um eine unterschiedlich verzögerte Version des periodischen Signals (PHI1) zu empfangen, zum Erfassen, ob eine Flanke des periodischen Signals in einer derartigen jeweiligen Version gegenwärtig ist, wobei eine (144) der Flankenerfassereinrichtungen durch das periodische Signal getriggert wird, um eine Flankenerfassung durchzuführen, und wobei jede andere (146, 148) der Flankenerfassereinrichtungen durch das Ausgangssignal einer Flankenerfassereinrichtung getriggert wird, wobei die Mehrzahl der Flankenerfassereinrichtungen dadurch eine mit einer anderen seriell verbunden sind; und
eine erste Zwischenspeichereinrichtung (138), die durch das periodische Signal (PHI1) getriggert wird, und die wirksam mit dem Ausgang der zuletzt verbundenen (148) der Mehrzahl von Flankenerfassereinrichtungen verbunden ist, zum Erzeugen eines Ausgangssignals, das das gegenwärtige Ausgangssignal der zuletzt verbundenen der Mehrzahl von Flankenerfassereinrichtungen anzeigt, während die erste Zwischenspeichereinrichtung (138) durch das periodische Signal getriggert wird, wobei das Ausgangssignal, während die erste Zwischenspeichereinrichtung nicht durch das periodische Signal getriggert wird, das Ausgangssignal der zuletzt verbundenen (148) der Mehrzahl von Flankenerfassereinrichtungen anzeigt als das periodische Signal zuletzt die erste Zwischenspeichereinrichtung getriggert hatte.
wodurch das Ausgangssignal, das durch die erste Zwischenspeichereinrichtung (138) erzeugt wird, einen Phasenfehler anzeigt, es sei denn, daß Flanken in den jeweiligen unterschiedlich verzögerten Versionen des periodischen Signals (PHI1) durch die Mehrzahl der Flankenerfassereinrichtungen in einer vorbestimmten Reihenfolge erfaßt werden, während das periodische Signal sowohl die Mehrzahl der Flankenerfassereinrichtungen als auch die erste Zwischenspeichereinrichtung triggert.

2. Vorrichtung gemäß Anspruch 1, ferner dadurch gekennzeichnet, daßpdie erste Zwischenspeichereinrichtung ein transparentes Latch aufweist.

3. Vorrichtung gemäß Anspruch 1, ferner dadurch gekennzeichnet, daß die Mehrzahl von Flankenerfassereinrichtungen mindestens drei Flankenerfassereinrichtungen aufweist.

## Revendications

1. Appareil (72) de détection d'erreurs de phase dans un signal périodique (PHI1), caractérisé en ce qu'il comprend :
une pluralité de moyens détecteurs de flanc (144, 146, 148), chacun desdits moyens détecteurs de flanc étant connecté de façon à recevoir une version différemment retardée du signal périodique (PHI1), afin de déterminer si un flanc du signal périodique est ou non présent dans la version respective, où l'un (144) desdits moyens détecteurs de flanc est déclenché, de façon à effectuer la détection de flanc, par le signal périodique, et chacun desdits autres détecteurs de flanc (146, 148) est déclenché par le signal de sortie d'un moyen détecteur de flanc, ladite pluralité de moyens détecteurs de flanc étant ainsi connectée en série les uns avec les autres ; et
un premier moyen de verrouillage (138), déclenché par le signal périodique (PHI1) et fonctionnellement connecté à la sortie du moyen détecteur de flanc connecté en dernier (148) de ladite pluralité de moyens détecteurs de flanc, afin de produire un signal de sortie indicatif du signal de sortie courant dudit moyen détecteur de flanc connecté en dernier de ladite pluralité de moyens détecteurs de flanc pendant que ledit premier moyen de verrouillage (138) est déclenché par le signal périodique, le signal de sortie étant indicatif, pendant que ledit premier moyen de verrouillage n'est pas déclenché par le signal périodique, du signal de sortie dudit moyen détecteur de flanc connecté en dernier (148) de ladite pluralité de moyens détecteurs de flanc pendant que le signal périodique déclenchait la dernière fois ledit premier moyen de verrouillage,
si bien que le signal de sortie produit par ledit premier moyen de verrouillage (138) est indicatif d'une erreur de phase à moins que des flancs ne soient détectés dans les versions différemment retardées respectives du signal périodique (PHI1) par ladite pluralité de moyens détecteurs de flanc suivant une séquence prédéterminée pendant que le signal périodique déclenche à la fois ladite pluralité de moyens détecteurs de flanc et ledit premier moyen de verrouillage.

2. Appareil selon la revendication 1, caractérisé en outre en ce que ledit premier moyen de verrouillage comprend un dispositif de verrouillage transparent.

3. Appareil selon la revendication 1, caractérisé en outre en ce que ladite pluralité de moyens détecteurs de flanc comprend au moins trois moyens détecteurs de flanc.
